(19)

**Europäisches Patentamt**
**European Patent Office**
**Office européen des brevets**

(11) **EP 2 554 031 B1**

(12) **EUROPEAN PATENT SPECIFICATION**

(45) Date of publication and mention
of the grant of the patent:
**07.06.2017 Bulletin 2017/23**

(51) Int Cl.:
*H05K 7/20* *(2006.01)*      *F28F 3/00* *(2006.01)*
*F28D 9/00* *(2006.01)*      *F28F 3/02* *(2006.01)*

(21) Application number: **10861259.9**

(86) International application number:
**PCT/CN2010/080615**

(22) Date of filing: **31.12.2010**

(87) International publication number:
**WO 2012/088713 (05.07.2012 Gazette 2012/27)**

(54) **METHOD AND DEVICE OF HEAT TRANSPORT**

VERFAHREN UND VORRICHTUNG FÜR WÄRMEÜBERTRAGUNG

PROCÉDÉ ET DISPOSITIF DE TRANSPORT DE CHALEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.02.2013 Bulletin 2013/06**

(73) Proprietor: **Huawei Technologies Co., Ltd.
Longgang District
Shenzhen, Guangdong 518129 (CN)**

(72) Inventor: **TSOI, Vadim
S-164 94 Kista (SE)**

(74) Representative: **Kreuz, Georg Maria et al
Huawei Technologies Duesseldorf GmbH
Riesstrasse 8
80992 München (DE)**

(56) References cited:
**WO-A1-2010/145434      CN-Y- 2 839 943
CN-Y- 201 066 252      CN-Y- 201 242 379
JP-A- H11 166 795      US-A- 5 884 691
US-B1- 6 789 612**

EP 2 554 031 B1

**Description**

**Technical field**

The present invention relates to a technical field of heat transport by means of an air-to-air heat exchanger and to use and manufacturing of such a heat exchanger.

**Background**

US patent no. 5 785 117 discloses a core assembly for use in an air-to-air heat exchanger. The core is comprised of a plurality of square plates. Each plate is comprised of a square planar central region; a first pair of opposed edge flanges bent in a first direction with respect to the central region to form approximately 90 degree angle with the central region; and a second pair of opposed edge flanges bent in a direction opposite the first direction with respect to the central region to form approximately 90 degree angle with the central region. The core is formed by the plurality of square plates that are positioned into a stack of parallel plates such that the opposed flanges of one of the plurality of plates is located in contact with and inside mating opposed flanges of a plate directly adjacent thereto, thereby forming a plurality of air passages between adjacent plates such that two perpendicular air pathways are formed in an interleaved orientation. A frame is provided in contact with a bottom plate in the stack and a top plate in the stack for holding the plurality of plates in position.

US patent no. 4 681 155 discloses a heat exchanger comprising a plurality of preassembled heat exchanger tubes separated by cooling fins. Each tube is formed from two identical U-shaped members having a folded and unfolded end. The unfolded end of each is slid into the fold end of the other.

US patent no. 6 789 612 discloses a cooling device for cooling an inner part of an approximately sealed box. It includes a casing and a heat exchanger disposed in the casing. Plural inside air passages through which air flows inside the box, and plural outside air passages through which air flows outside the box, are alternately adjacently arranged in the heat exchanger. In the cooling device, both outside air introduction port and outside air discharge port are provided in an outer side plate of the casing, and a drain space is provided between the heat exchanger and the outer side plate of the casing so that outside air passages communicate with the outside air discharge port through the drain space. JP11-166795A describes a heat exchanger including a heating tube including a plurality of channels therein, and a mixing chamber. Gas is lead into the mixing chamber and mixed with the liquid flowing in the channels therein.

**Summary**

An object of an embodiment of the invention is to reduce the risk that water enters from an outdoor environment to an indoor environment of a heat exchanger.

A further object of an embodiment of the invention is to provide a heat exchanger capable of operating at low fan power.

It is also an object of an embodiment of the invention to provide a heat exchanger of reduced sensitivity to fire or mechanical damages.

Embodiments of the invention provide a heat exchanger capable of, e.g., being installed in an outdoor-climate environment or mounted in the ceiling of a cabinet comprising electronic circuitry as described further in the detailed description below. It also provides detailed example use and manufacturing thereof.

**Brief description of the drawings**

In the following detailed portion of the present description, the invention will be explained in more detail with reference to example embodiments shown in drawing, in which:

Fig. 1a shows a main component of an example air-to-air heat exchanger in accordance with the invention,
Fig. 1b shows the component of fig. 1a for example installation in a cabinet, such as for containing a telecommunications equipment,
fig. 2a and 2b show two embodiments of a first structure with walls separating individual flow passages,
fig. 3 shows a heat transfer structure arranged inside the individual flow passages,
fig. 4a and 4b show cross-sectional views through one embodiment of the component of fig. 1,
Fig. 5a and 5b are similar to fig. 4a and 4b but show another arrangement of the heat transfer structures, and
Fig. 6 shows a method of securing the heat transfer structures in place within the first structure.

**Detailed description**

It is a problem of a heat exchanger that water may enter the structure so that use thereof in an outdoor environment requires particular measures to provide a more indoor-like climate.

It is also a problem of prior art solutions that extensive minor flow passages defined by fins or other corresponding internal structures may also give rise to a high pressure drop, with a corresponding high power consumption of the fan driving the air through the heat-exchanger. Making the minor flow passages wider would reduce the pressure drop but also the transferred heat energy.

An embodiment of the invention is based on the finding that by providing several heat transfer structures along the length of the flow path through the heat exchanger the fan power needed for driving the air through the heat exchanger is reduced significantly without a corresponding significant loss in the cooling capacity. This is achieved by the first air flow passages and/or the second air flow passages each including at least two heat transfer structures arranged in a spaced apart relationship in a direction of air flow through the air flow passages, a plenum between two adjacent heat transfer structures being defined in part by the separating walls of the first structure. With this configuration all or substantially all air flow through a first air flow passage and/or a second air flow passage flows first through the minor flow passages of a heat transfer structure, then through a plenum and then through the minor flow passages of a next heat transfer structure.

A theoretical background behind the latter embodiment believed to be as follows.

Two very important properties of a heat exchanger are its cooling capacity based on the heat transfer coefficient *h (W/m2K)* and the heat exchange area as well as the hydraulic resistance or pressure drop for air passing through the heat exchanger. A high flow resistance requires high fan power consumption and may increase the level of noise generated by the heat exchanger.

Relevant formulae showing the relationship between the above properties are:

$$Q = h * A * (T1-T2), \qquad \text{(Equation 1)}$$

where Q is transferred Heat, A the heat transferring area and T1-T2 is a temperature difference.

$$Pd = F * L/D * V^2 *Ro/2, \qquad \text{(Equation 2)}$$

where Pd is pressure drop, F a Reynolds dependent coefficient (different for turbulent and laminar flow), D is the equivalent diameter of the passage or channel (4*S/U S is the area of channel, U is channel's perimeter), V air velocity and Ro is the air density.

$$h = Nu*L/D, \qquad \text{(Equation 3)}$$

where Nu is Nusselt number and L is the lambda value.

From the above formulae it is apparent that *h* is higher in smaller and shorter channels in comparison with a traditional heat exchanger flow passage. It can also be seen that the pressure drop Pd becomes lower with the present heat exchanger. Using two or more heat transfer structures leads to an increased heat exchanger area and in combination with a better *h* and Pd results in a more efficient heat exchanger with a high cooling capacity and a low pressure drop.

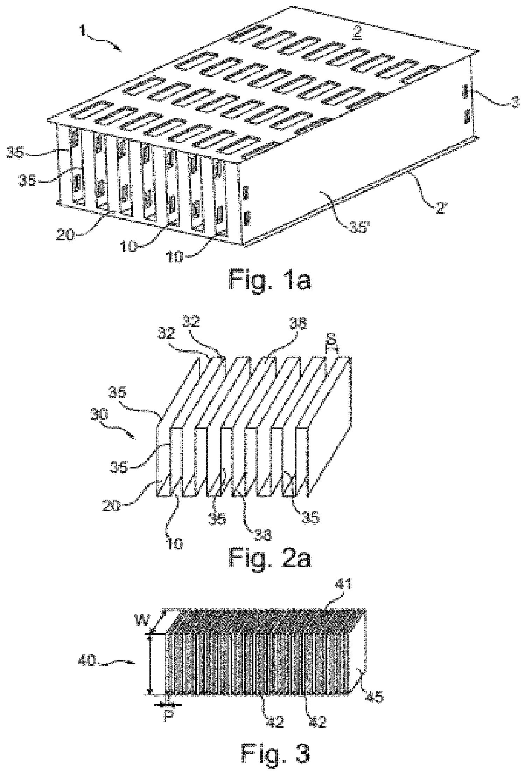

Fig. 1a shows a main component of an air-to-air heat exchanger according to an embodiment of the invention and referenced generally by numeral 1. The component includes parallel opposed top and bottom walls 2, 2' and parallel opposed outer side walls 35'. A plurality of internal and parallel separating walls 35 are arranged perpendicularly to the top and bottom walls 2 and in parallel with the outer side walls 35'. The separating walls 35 define a plurality of parallel flow passages, of which first flow passages 10 receive a through-flow of low temperature air while second flow passages 20 receive a through-flow of high temperature air, such as from a space below the heat exchanger.

The first 10 and second 20 flow passages are arranged adjacent each other alternatingly along the width of the component 1 between the outer side walls 35'. Each flow passage 10, 20 includes one or more heat transfer structures 40, to be discussed below. When incorporating more than one heat transfer structure 40 in each flow passage 10, 20 they are spaced apart in the flow direction. The heat transfer structures 40 provide an efficient heat exchange between the high and low temperature air flows. As shown, the first air flow passages 10 open up at an air lead-in or inlet at one of the opposite ends 3 of the component 1, and at an air lead out or outlet at the opposite end 3. The second air flow passages 20 are closed at the opposite ends 3 of the component 1 and open up at an air lead in near or adjacent to a respective end 3 through apertures formed in the bottom wall 2'. Air may be driven along the length of the air flow passages 10, 20 between opposed ends 3 by means of fans (not shown).

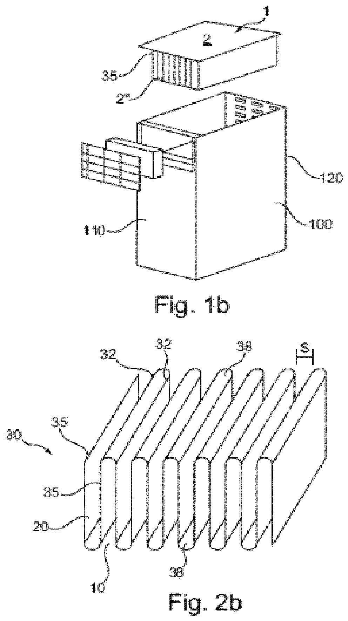

Fig. 2a shows a structure 30 defining the internal parallel separating walls 35 and illustrating the flow passages 10, 20. The structure 30 may be manufactured by folding a metal plate in an accordion-like manner along lines that are to extend parallel with a first linear extension L of the heat-exchanger component 1; while fig. 2a shows the folds 32 as defining sharp edges and planar connecting walls 38 other configurations, such as slightly curved end portions as shown in fig. 2b, may be envisaged. The inside distance or spacing s between adjacent separating walls 35 is preferably selected to be greater than 8 mm, preferably in the order of 10-20 mm. Preferably the separating walls 35 are spaced apart by the same distance s.

Fig. 3 shows one of a plurality of heat transfer structures 40 arranged inside the flow passages 10, 20. While such structures 40 could be arranged in the first flow passages 10 or in the second flow passages 20 only it is preferred that they be arranged in all flow passages 10, 20. The heat transfer structures 40 include a plurality of spaced apart parallel partitions 45, with the inside distance p between adjacent partitions 45 preferably being less than 6 mm, most preferably in the order of 2-3 mm. Preferably the partitions 45 are spaced apart by the same distance p. A width w of the heat transfer structures 40 corresponds to the internal spacing s between the separating walls 35 such that the heat transfer structures 40 when mounted inside the flow passages 10, 20 contact the separating walls 35 to allow for an efficient conduction of heat between air flowing in the first and second passages 10, 20 through minor flow passages 42 between the partitions 45. Preferably, the heat transfer structures 40 are folded structures manufactured as the first structure 30 described above, with connecting end portions or walls 41 abutting, preferably in an airtight manner through a soldering process, the separating walls 35. Air flow passages, in the following referred to as 'minor flow passages' are defined by the space between opposite partitions 45.

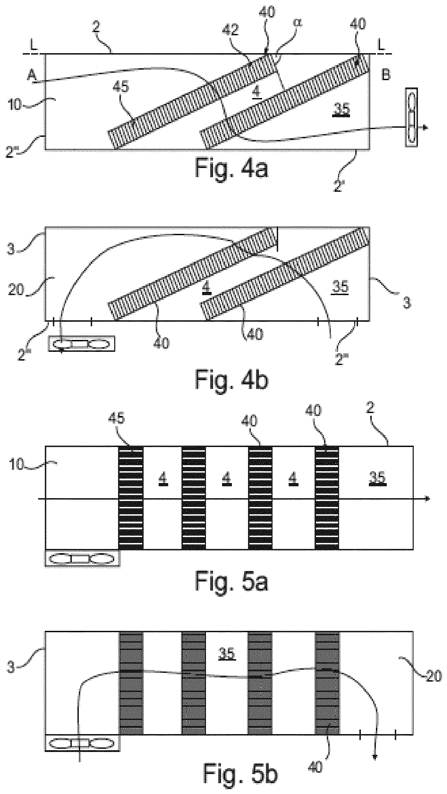

Fig. 4a and 4b show cross-sectional views through the component 1 of fig. 1a, showing the arrangement of the heat transfer structures 40 in each of the first flow passages 10 and in each of the second flow passages 20, respectively. The separating walls 35 extend between the first side A and the second side B of the component 1 at a respective end 3. The drawings show schematically how the air flows through the flow passages between the opposite ends 3 of the component 1, reference numeral 2" designating the aforementioned apertures defining a respective air lead-in or inlet 2" formed in the bottom wall 2'. Fig. 5a and 5b are similar to fig. 4a and 4b but show another arrangement of the heat transfer structures 40. As can be seen, the heat transfer structures 40 span the distance between the top and bottom wall 2, 2', and between opposite separating walls 35, whereby air entering the flow passages 10, 20 will flow through the plurality of minor air flow passages 42 formed by the spaced apart partitions 45; air exiting one heat transfer structure 40 will enter a plenum or space 4, and then enter the minor air flow passages 42 of the next heat transfer structure 40.

As shown, the heat transfer structures 40 may, depending on the dimensions of the component 1, i.e. the distance between the top and bottom wall 2, 2' and the distance between the opposite ends 3, be arranged with the partitions 45 at an acute angle $\alpha$, such as an angle $\alpha$ in the range of 20°-70°, with respect to the aforementioned linear dimension L between the opposite ends 3, or at an angle $\alpha$ of 0°, as shown in fig. 5a. An arrangement as shown in fig. 4a and 4b has proven advantageous in that an efficient heat transfer is achieved over the distance between the opposite ends 3 with, with a limited manufacturing effort since a fewer number of heat transfer structures 40 are required.

Fig. 4a and 4b show an embodiment where only two heat transfer structures 40 that are inclined to define angle $\alpha$, are arranged in each flow passage 10, 20 within the component 1. It will be understood that additional heat transfer structures 40 may be placed within each flow passage; fig. 5a and 5b show a total of five heat transfer structures 40 placed within each flow passage 10, 20. Different numbers of heat transfer structures 40 may even be arranged within neighbouring flow passages 10, 20.

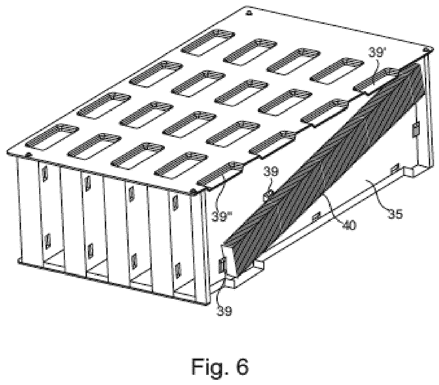

Fig. 6 shows a method of securing the heat transfer structures 40 in place within the air flow passages 10, 20. The figure shows an embodiment of the first structure 30 where separate preformed separating walls 35 with integrally formed flanges defining the connecting walls 38 and opposite walls at the sides A and B have been joined. As shown, the separating walls 35 include integrally formed and mechanically raised areas 39, 39' that contact and secure a respective heat transfer structure 40 against movement with respect to the separating walls 35; raised areas may be formed by a press acting locally on the surface of the separating walls 35. Preferably also the top and bottom walls have such raised areas 39" contacting and securing the heat transfer structure 40.

Preferably, the heat exchanger component 1 is manufactured in the way where the heat transfer structures 40 are temporarily held in the spaced apart relationship and wherein the heat transfer structures 40 are then soldered to the separating walls 35 through a brazing process.

Fig. 1b shows a practical application of the heat exchanger in an outdoor cabinet 100 containing telecommunications equipment and having a front wall 110 and an opposite rear wall 120, the separating walls 35 of the first structure 30 extending between the front wall and said rear wall, the low temperature air lead in being at the front wall 110 while the high temperature lead in may be apertures 2" in bottom wall 2' as shown in fig. 4b and 5b.

The corrugated structures may be formed by folding a metal plate; alternatively, the corrugated structure may be manufactured by extrusion.

**Claims**

1. An air-to-air heat exchanger (1) having a first side (A) and a second side (B), and comprising:

   one or more first structures (30) comprising spaced apart separating walls (35) extending between said first side (A) and said second side (B) forming at least in part a plurality of first passages (10) and a plurality of second passages (20), each one of said plurality of first passages (10) being arranged adjacent to and in parallel with at least one of said plurality of second passages (20),
   at least one heat transfer structure (40) arranged in said first and second passages (10, 20), said heat transfer structure (40) contacting a respective separating wall (35) and including spaced apart partitions (45) defining a plurality of minor flow passages (42), wherein said heat transfer structures (40) are arranged between said first side (A) and said second side (B),

   **characterized in that**, the heat exchanger further comprises:

   respective inlets and outlets (2") of said first and second passages (10, 20), the inlets and outlets of said first passages being formed on the first side (A) and the second side (B) respectively, the inlets and outlets (2") of said second passages (20) being formed in a bottom wall (2') of the heat exchanger, wherein the first passages (10) are configured to receive a through-flow of low temperature air, the second passages (20) are configured to receive a through-flow of high temperature air from a space below the heat exchanger (1).

2. The air-to-air heat exchanger according to claim 1, comprising connecting walls (38) connecting said separating walls (35), said separating walls (35) and the connecting walls (38) defining first and second passages (10,20), the inlets and outlets (2") of said second passages (20) being formed in at least one of said connecting walls (38).

3. The air-to-air heat exchanger according to claim 1, wherein said second side (B) is parallel with said first side (A).

4. The air-to-air heat exchanger according to claim 1, wherein said inlets and/or outlets (2") of said first passages (10) are formed at said first side (A) or at said second side (B).

5. The air-to-air heat exchanger according to any of the preceding claims, said first passages (10) and/or said second passages (20) each including at least two of said heat transfer structures (40) arranged in a spaced apart relationship between said first side (A) and said second side (B), a plenum (4) between two adjacent heat transfer structures (40) being defined in part by two separating walls (35) of said first structure (30).

6. The air-to-air heat exchanger according to any of the preceding claims, said first structure (30) or said heat transfer structure (40) comprising one or more folded metal plates.

7. The air-to-air heat exchanger according to claim 1, wherein said one or more first structures comprises a corrugated sheet separating the first passages from the second passages.

8. The air-to-air heat exchanger according to claim 1, wherein said one or more first structures comprises a plurality U-shaped profiles arranged in a series having a cross-section comprising a series of Us.

9. The air-to-air heat exchanger according to any of the preceding claims, said separating walls (35) of said first structure (30) being spaced apart by more than 5 mm.

10. The air-to-air heat exchanger according to the preceding claim, said separating walls (35) of said first structure (30) being spaced apart by 5-30 mm.

11. The air-to-air heat exchanger according to any of the preceding claims, said separating walls (35) of said first or second passages being spaced apart by the same distance.

12. The air-to-air heat exchanger according to any of the preceding claims, said partitions (45) of said heat transfer structures (40) extending at an angle, $\alpha$, less than 90° to an axis (L) of said first or second passages (10, 20).

13. The air-to-air heat exchanger according to the preceding claim, said angle $\alpha$ being equal to or less than 75°.

14. The air-to-air heat exchanger according to any of the preceding claims, said partitions (45) of said heat transfer structures (40) being spaced apart by less than 4 mm.

15. The air-to-air heat exchanger according to the preceding claim, said partitions (45) of said heat transfer structures (40) being spaced apart by 1-3 mm.

16. The air-to-air heat exchanger according to any of the preceding claims, said partitions (45) of said heat transfer structures (40) being spaced apart by the same distance (p).

17. A system product of heat exchange comprising a cabinet and a heat exchanger, the system product **characterized by** a heat exchanger according to claim 1;
wherein
the heat exchanger provides a water resistant seal between the first and second passages; and
the heat exchanger is arranged in or forms the ceiling of the cabinet.

18. The system product of air-to-air heat exchange according to claim 17, wherein the front side of the cabinet comprises said first (110) or second (120) side.


**Patentansprüche**

1. Luft-Luft-Wärmetauscher (1), welcher eine erste Seite (A) und eine zweite Seite (B) aufweist und umfasst:

   eine oder mehrere erste Strukturen (30), die beabstandete Trennwände (35) umfassen, die sich zwischen der ersten Seite (A) und der zweiten Seite (B) erstrecken und wenigstens teilweise eine Vielzahl von ersten Durchlässen (10) und eine Vielzahl von zweiten Durchlässen (20) bilden, wobei jeder der Vielzahl von ersten Durchlässen (10) zu wenigstens einem der Vielzahl von zweiten Durchlässen (20) benachbart und parallel angeordnet ist,
   wenigstens eine Wärmeübertragungsstruktur (40), die in den ersten und zweiten Durchlässen (10, 20) angeordnet ist, wobei die Wärmeübertragungsstruktur (40) eine jeweilige Trennwand (35) berührt und beabstandete Zwischenwände (45) aufweist, die eine Vielzahl von kleinen Strömungskanälen (42) definieren, wobei die Wärmeübertragungsstrukturen (40) zwischen der ersten Seite (A) und der zweiten Seite (B) angeordnet sind,
   **dadurch gekennzeichnet, dass** der Wärmetauscher ferner umfasst:

   jeweilige Einlässe und Auslässe (2") der ersten und zweiten Durchlässe (10, 20), wobei die Einlässe und Auslässe der ersten Durchlässe auf der ersten Seite (A) bzw. der zweiten Seite (B) ausgebildet sind, die Einlässe und Auslässe (2") der zweiten Durchlässe (20) in einer Bodenwand (2') des Wärmetauschers ausgebildet sind, wobei die ersten Durchlässe (10) dafür ausgelegt sind, einen Durchfluss von Luft niedriger Temperatur aufzunehmen, und die zweiten Durchlässe (20) dafür ausgelegt sind, einen Durchfluss von Luft hoher Temperatur aus einem Raum unterhalb des Wärmetauschers (1) aufzunehmen.

2. Luft-Luft-Wärmetauscher nach Anspruch 1, welcher Verbindungswände (38) umfasst, welche die Trennwände (35) verbinden, wobei die Trennwände (35) und die Verbindungswände (38) erste und zweite Durchlässe (10, 20) definieren, wobei die Einlässe und Auslässe (2") der zweiten Durchlässe (20) in wenigstens einer der Verbindungswände (38) ausgebildet sind.

3. Luft-Luft-Wärmetauscher nach Anspruch 1, wobei die zweite Seite (B) parallel zu der ersten Seite (A) ist.

4. Luft-Luft-Wärmetauscher nach Anspruch 1, wobei die Einlässe und/oder Auslässe (2") der ersten Durchlässe (10) an der ersten Seite (A) oder an der zweiten Seite (B) ausgebildet sind.

5. Luft-Luft-Wärmetauscher nach einem der vorhergehenden Ansprüche, wobei die ersten Durchlässe (10) und/oder die zweiten Durchlässe (20) jeweils wenigstens zwei der Wärmeübertragungsstrukturen (40) aufweisen, die in einer beabstandeten Beziehung zwischen der ersten Seite (A) und der zweiten Seite (B) angeordnet sind, wobei eine Luftkammer (4) zwischen zwei benachbarten Wärmeübertragungsstrukturen (40) teilweise durch zwei Trennwände (35) der ersten Struktur (30) definiert ist.

6. Luft-Luft-Wärmetauscher nach einem der vorhergehenden Ansprüche, wobei die erste Struktur (30) oder die Wärmeübertragungsstruktur (40) eine oder mehrere gefaltete Metallplatten umfasst.

7.  Luft-Luft-Wärmetauscher nach Anspruch 1, wobei die eine oder die mehreren ersten Strukturen ein Wellblech umfassen, das die ersten Durchlässe von den zweiten Durchlässen trennt.

8.  Luft-Luft-Wärmetauscher nach Anspruch 1, wobei die eine oder die mehreren ersten Strukturen eine Vielzahl von in einer Reihe angeordneten U-förmigen Profilen mit einem Querschnitt umfassen, der eine Reihe von "U"s umfasst.

9.  Luft-Luft-Wärmetauscher nach einem der vorhergehenden Ansprüche, wobei die Trennwände (35) der ersten Struktur (30) um mehr als 5 mm beabstandet sind.

10. Luft-Luft-Wärmetauscher nach dem vorhergehenden Anspruch, wobei die Trennwände (35) der ersten Struktur (30) um 5-30 mm beabstandet sind.

11. Luft-Luft-Wärmetauscher nach einem der vorhergehenden Ansprüche, wobei die Trennwände (35) der ersten oder zweiten Durchlässe um denselben Abstand beabstandet sind.

12. Luft-Luft-Wärmetauscher nach einem der vorhergehenden Ansprüche, wobei sich die Zwischenwände (45) der Wärmeübertragungsstrukturen (40) unter einem Winkel $\alpha$ von weniger als 90° zu einer Achse (L) der ersten oder zweiten Durchlässe (10, 20) erstrecken.

13. Luft-Luft-Wärmetauscher nach dem vorhergehenden Anspruch, wobei der Winkel $\alpha$ gleich oder kleiner als 75° ist.

14. Luft-Luft-Wärmetauscher nach einem der vorhergehenden Ansprüche, wobei die Zwischenwände (45) der Wärmeübertragungsstrukturen (40) um weniger als 4 mm beabstandet sind.

15. Luft-Luft-Wärmetauscher nach dem vorhergehenden Anspruch, wobei die Zwischenwände (45) der Wärmeübertragungsstrukturen (40) um 1-3 mm beabstandet sind.

16. Luft-Luft-Wärmetauscher nach einem der vorhergehenden Ansprüche, wobei die Zwischenwände (45) der Wärmeübertragungsstrukturen (40) um denselben Abstand (p) beabstandet sind.

17. Systemprodukt für den Wärmeaustausch, welches einen Schrank und einen Wärmetauscher umfasst, wobei das Systemprodukt **gekennzeichnet ist durch**
einen Wärmetauscher nach Anspruch 1;
wobei
der Wärmetauscher eine wasserfeste Dichtung zwischen den ersten und zweiten Durchlässen gewährleistet; und
der Wärmetauscher in der Decke des Schrankes angeordnet ist oder diese bildet.

18. Systemprodukt für den Luft-Luft-Wärmeaustausch nach Anspruch 17, wobei die Vorderseite des Schrankes die erste (110) oder zweite (120) Seite umfasst.

## Revendications

1.  Echangeur de chaleur air-air (1) présentant un premier côté (A) et un second côté (B), et comprenant:

    une ou plusieurs première(s) structure(s) (30) comprenant des parois de séparation espacées les unes des autres (35) qui s'étendent entre ledit premier côté (A) et ledit second côté (B), formant au moins en partie une pluralité de premiers passages (10) et une pluralité de seconds passages (20), chacun de ladite pluralité de premiers passages (10) étant agencé à proximité de et parallèlement à au moins un de ladite pluralité de seconds passages (20),
    au moins une structure de transfert de chaleur (40) agencée dans lesdits premiers et seconds passages (10, 20), ladite structure de transfert de chaleur (40) étant en contact avec une paroi de séparation respective (35) et comprenant des cloisons espacées les unes des autres (45) qui définissent une pluralité de passages d'écoulement mineurs (42), dans lequel lesdites structures de transfert de chaleur (40) sont agencées entre ledit premier côté (A) et ledit second côté (B),
    **caractérisé en ce que** l'échangeur de chaleur comprend en outre:

des entrées et des sorties respectives (2") desdits premiers et seconds passages (10, 20), les entrées et les sorties desdits premiers passages étant formées sur le premier côté (A) et le second côté (B), respectivement, les entrée et les sorties (2") desdits seconds passages (20) étant formées dans une paroi inférieure (2') de l'échangeur de chaleur, dans lequel les premiers passages (10) sont configurés de manière à recevoir un écoulement traversant d'air à basse température, et les seconds passages (20) sont configurés de manière à recevoir un écoulement traversant d'air à haute température en provenance d'un espace situé en dessous de l'échangeur de chaleur (1).

2. Echangeur de chaleur air-air selon la revendication 1, comprenant des parois de connexion (38) qui relient lesdites parois de séparation (35), lesdites parois de séparation (35) et les parois de connexion (38) définissant des premiers et seconds passages (10, 20), les entrées et les sorties (2") desdits seconds passages (20) étant formées dans au moins une desdites parois de connexion (38).

3. Echangeur de chaleur air-air selon la revendication 1, dans lequel ledit second côté (B) est parallèle audit premier côté (A).

4. Echangeur de chaleur air-air selon la revendication 1, dans lequel lesdites entrées et/ou lesdites sorties (2") desdits premiers passages (10) sont formées au niveau dudit premier côté (A) ou au niveau dudit second côté (B)

5. Echangeur de chaleur air-air selon l'une quelconque des revendications précédentes, dans lequel lesdits premiers passages (10) et/ou lesdits seconds passages (20) présentent chacun au moins deux desdites structures de transfert de chaleur (40) agencées dans une relation espacée entre ledit premier côté (A) et ledit second côté (B), un plénum (4) entre deux structures de transfert de chaleur adjacentes (40) étant défini en partie par deux parois de séparation (35) de ladite première structure (30).

6. Echangeur de chaleur air-air selon l'une quelconque des revendications précédentes, dans lequel ladite première structure de transfert de chaleur (30) ou ladite deuxième structure de transfert de chaleur (40) comprend une ou plusieurs plaques métalliques pliées.

7. Echangeur de chaleur air-air selon la revendication 1, dans lequel ladite/lesdites une ou plusieurs structure(s) comprend/comprennent une feuille ondulée qui sépare les premiers passages des seconds passages.

8. Echangeur de chaleur air-air selon la revendication 1, dans lequel ladite/lesdites une ou plusieurs structure(s) comprend/comprennent une pluralité de profils en forme de U agencés en une série présentant une section transversale comprenant une série de U.

9. Echangeur de chaleur air-air selon l'une quelconque des revendications précédentes, dans lequel lesdites parois de séparation (35) de ladite première structure (30) sont espacées les une des autres de plus de 5 mm.

10. Echangeur de chaleur air-air selon l'une quelconque des revendications précédentes, dans lequel lesdites parois de séparation (35) de ladite première structure (30) sont espacées les une des autres de 5 mm à 30 mm.

11. Echangeur de chaleur air-air selon l'une quelconque des revendications précédentes, dans lequel lesdites parois de séparation (35) desdits premiers ou seconds passages sont espacées les unes des autres de la même distance.

12. Echangeur de chaleur air-air selon l'une quelconque des revendications précédentes, dans lequel lesdites cloisons (45) desdites structures de transfert de chaleur (40) s'étendent selon un angle, $\alpha$, qui est inférieur à 90° par rapport à un axe (L) desdits premiers ou seconds passages (10, 20).

13. Echangeur de chaleur air-air selon l'une quelconque des revendications précédentes, dans lequel ledit angle $\alpha$ est égal ou inférieur à 75°.

14. Echangeur de chaleur air-air selon l'une quelconque des revendications précédentes, dans lesdites cloisons (45) desdites structures de transfert de chaleur (40) sont espacées les unes des autres de moins de 4 mm.

15. Echangeur de chaleur air-air selon l'une quelconque des revendications précédentes, dans lequel lesdites cloisons (45) desdites structures de transfert de chaleur (40) sont espacées les unes des autres de 1 mm à 3 mm.

**16.** Echangeur de chaleur air-air selon l'une quelconque des revendications précédentes, dans lequel lesdites cloisons (45) desdites structures de transfert de chaleur (40) sont espacées les unes des autres de la même distance (p).

**17.** Produit de système d'échange de chaleur comprenant une armoire et un échangeur de chaleur, le produit de système étant **caractérisé par**:

un échangeur de chaleur selon le revendication 1,
dans lequel:

l'échangeur de chaleur fournit un joint résistant à l'eau entre les premiers et seconds passages; et
l'échangeur de chaleur est agencé dans ou forme le le plafond de l'armoire.

**18.** Produit de système d'échange de chaleur air-air selon la revendication 17, dans lequel le côté avant de l'armoire comprend ledit premier côté (110) ou ledit second côté (120).

Fig. 1a

Fig. 2a

Fig. 3

Fig. 1b

Fig. 2b

Fig. 4a

Fig. 4b

Fig. 5a

Fig. 5b

EP 2 554 031 B1

Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5785117 A
- US 4681155 A
- US 6789612 B
- JP 11166795 A